# EUROPEAN PATENT APPLICATION

(11) **EP 4 372 122 A2**
(43) Date of publication of application: **22.05.2024**
(21) Application number: 23206266.1
(22) Date of filing: 26.10.2023
(51) Int. Cl.: C23C 16/448, C23C 14/24

(54) **DEPOSITION SOURCE AND DEPOSITION APPARATUS INCLUDING THE SAME**

(30) Priority: 27.10.2022 KR 20220140691
(71) Applicant: Samsung Display Co., Ltd., Yongin-si, Gyeonggi-do 17113 (KR)
(72) Inventor: CHOI, JONGHYUN, 17113 Yongin-si (KR); SEO, MIN-GYU, 17113 Yongin-si (KR); SEOL, JAEWAN, 17113 Yongin-si (KR); YOON, INTAEK, 17113 Yongin-si (KR)
(74) Representative: Taor, Simon Edward William

(57) **Abstract**

A deposition source includes a first crucible, a second crucible disposed inside the first crucible, a block disposed inside the first crucible, the block being disposed on at least a portion of the second crucible, and a cover covering a top surface of the first crucible, the cover being disposed on the block.

## Description

### BACKGROUND

### 1. Technical Field

Embodiments of the disclosure relate to a deposition source and a deposition apparatus including the same, which are used in a deposition process.

### 2. Description of the Related Art

As a method for forming a thin film on a substrate, there are a physical vapor deposition (PVD) scheme such as a vacuum deposition (evaporation) scheme, an ion plating scheme, or a sputtering scheme, and a chemical vapor deposition (CVD) scheme by a gas reaction.

A deposition apparatus configured to perform the vacuum deposition scheme generally may have a deposition source including a crucible configured to store an evaporation material, a heater configured to heat the crucible, and a nozzle through which the evaporation material is discharged.

As such a deposition source, there is a linear deposition source having a shape elongated in a direction. The linear deposition source may be useful in forming a deposition film on a large-area substrate.

### SUMMARY

An aspect of the disclosure is to provide a deposition source with improved deposition quality.

Another aspect of the disclosure is to provide a deposition apparatus including the deposition source.

However, aspects of the disclosure are not limited to the above-described aspects, and may be variously expanded without departing from the idea and scope of the disclosure.

According to an embodiment, a deposition source may include a first crucible, a second crucible disposed inside the first crucible, a block disposed inside the first crucible, the block being disposed on at least a portion of the second crucible, and a cover covering a top surface of the first crucible, the cover being disposed on the block.

According to an embodiment, the second crucible may include a protruding part, the first crucible may include a seating part, and the protruding part may be seated on the seating part.

According to an embodiment, the second crucible may include a non-metal material.

According to an embodiment, the deposition source may further include a tray disposed between the first crucible and the second crucible.

According to an embodiment, the tray may be disposed inside the first crucible, and the tray may be disposed under the second crucible.

According to an embodiment, the tray may include a non-metal material.

According to an embodiment, the tray and the second crucible may include a same material.

According to an embodiment, the tray may be coupled to the first crucible.

According to an embodiment, the tray may be coupled to the first crucible with a bolt.

According to an embodiment, the first crucible may include a metal material.

According to an embodiment, the block may include: a first block, and a second block spaced apart from the first block.

According to an embodiment, the first block and the second block may face each other.

According to an embodiment, the deposition source may further include a sealing gasket disposed between the cover and the first crucible.

According to an embodiment, the sealing gasket may be disposed between the cover and the block.

According to an embodiment, the second crucible may store a deposition material inside the second crucible.

According to an embodiment, the deposition source may further include a nozzle that sprays the deposition material, and a connection structure connected to the first crucible and the nozzle. The connection structure may transfer the deposition material to the nozzle.

According to an embodiment, a deposition source may include a nozzle that sprays a deposition material, and a crucible connected to the nozzle. The crucible may include a non-metal material. The crucible may store the deposition material in an inside of the crucible.

According to an embodiment, the inside of the crucible may make direct contact with the deposition material.

According to an embodiment, the deposition source may further include a connection structure connecting the nozzle to the crucible.

According to an embodiment, the deposition source may further include a cover covering a top surface of the crucible.

According to an embodiment, the deposition source may further include a sealing gasket disposed between the cover and the crucible.

According to an embodiment, a deposition apparatus may include a substrate holder disposed inside a process chamber, the substrate holder fixing a substrate, and a deposition source facing the substrate holder. The deposition source may include a first crucible, a second crucible disposed inside the first crucible, a block disposed inside the first crucible, the block being disposed on at least a portion of the second crucible, and a cover covering a top surface of the first crucible, the cover being disposed on the block.

According to an embodiment, the second crucible may include a protruding part, the first crucible may include a seating part, and the protruding part may be seated on the seating part.

According to an embodiment, the deposition source may further include a tray disposed between the first crucible and the second crucible.

According to an embodiment, each of the second crucible and the tray may include a non-metal material.

According to an embodiment, the block may include a first block, and a second block spaced apart from the first block.

According to an embodiment, the first block and the second block may face each other.

According to a deposition source of embodiments of the disclosure, the deposition source may include a protruding part, a seating part, a tray, and a block, so that a second crucible inside a first crucible can be prevented from floating by a deposition material. Therefore, a change in a position of the second crucible can be prevented so that an evaporation surface area of the deposition material can be prevented from being changed, and since the change in the position of the second crucible is prevented, an interference with a flow of the deposition material can be minimized. Thus, deposition quality of the deposition source can be improved.

The deposition material can be prevented from being agglomerated and hardened in a lower portion of the second crucible, so that the second crucible can be readily detached from the first crucible. Therefore, maintenance and repair of the deposition source can be facilitated.

According to a deposition source of other embodiments of the disclosure, the deposition source may include only one crucible, so that a defect caused by floating of an additional crucible inside the deposition source due to a deposition material can be prevented. Therefore, an evaporation surface area of the deposition material stored inside a crucible can be prevented from being changed, and an interference with a flow of the deposition material caused by the crucible can be minimized. Thus, deposition quality of the deposition source can be improved.

According to an aspect, there is provided a deposition source as set out in claim 1. Additional features are set out in claims 2 to 11. According to an aspect, there is provided a deposition source as set out in claim 12. Additional features are set out in claims 13 to 15.

A deposition source may include only one crucible, and may include a non-metal material, so that peeling of the deposition material can be facilitated. Therefore, maintenance and repair of the deposition source can be facilitated.

However, effects of the disclosure are not limited to the above-described effects, and may be variously expanded without departing from the idea and scope of the disclosure.

### BRIEF DESCRIPTION OF THE DRAWINGS

FIG. 1 is a schematic sectional view schematically showing a deposition apparatus according to an embodiment of the disclosure.
FIG. 2 is an exploded schematic perspective view showing a crucible member included in a deposition source according to an embodiment of the disclosure.
FIG. 3 is a schematic sectional view showing the crucible member of FIG. 2.
FIG. 4 is an enlarged schematic sectional view showing region A of FIG. 3.
FIG. 5 is a schematic plan view showing the crucible member of FIG. 2.
FIG. 6 is a schematic sectional view for describing the crucible member included in the deposition source according to an embodiment of the disclosure.
FIG. 7 is an enlarged schematic sectional view showing region B of FIG. 6.
FIG. 8 is an enlarged schematic sectional view showing region C of FIG. 6.
FIG. 9 is an exploded schematic perspective view showing a crucible member included in a deposition source according to another embodiment of the disclosure.
FIG. 10 is a schematic sectional view showing the crucible member of FIG. 9.
FIG. 11 is a schematic sectional view for describing the crucible member included in the deposition source according to another embodiment of the disclosure.

### DETAILED DESCRIPTION OF THE EMBODIMENTS

Hereinafter, embodiments of the disclosure will be described in more detail with reference to the accompanying drawings. This disclosure may, however, be embodied in different forms and should not be construed as limited to the embodiments set forth herein. Rather, these embodiments are provided so that this disclosure will be thorough and complete, and will fully convey the scope of the disclosure to those skilled in the art.

The same reference numerals will be used for the same elements in the drawings, and redundant descriptions of the same elements will be omitted.

In the drawings, sizes, thicknesses, ratios, and dimensions of the elements may be exaggerated for ease of description and for clarity.

As used herein, the singular forms, "a," "an," and "the" are intended to include the plural forms as well, unless the context clearly indicates otherwise.

In the specification and the claims, the term "and/or" is intended to include any combination of the terms "and" and "or" for the purpose of its meaning and interpretation. For example, "A and/or B" may be understood to mean any combination including "A, B, or A and B." The terms "and" and "or" may be used in the conjunctive or disjunctive sense and may be understood to be equivalent to "and/or."

It will be understood that, although the terms first, second, etc., may be used herein to describe various elements, these elements should not be limited by these terms. These terms are only used to distinguish one element from another element. For example, a first element may be referred to as a second element, and similarly, a second element may be referred to as a first element without departing from the scope of the disclosure.

The terms "face" and "facing" mean that a first element may directly or indirectly oppose a second element. In a case in which a third element intervenes between the first and second element, the first and second element may be understood as being indirectly opposed to one another, although still facing each other.

It will be understood that the terms "connected to" or "coupled to" may include a physical, fluid, and/or electrical connection or coupling.

The term "crucible" as used herein may mean a container or a container that may be subjected to a temperature.

Unless otherwise defined or implied herein, all terms (including technical and scientific terms) used herein have the same meaning as commonly understood by one of ordinary skill in the art to which the disclosure pertains. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

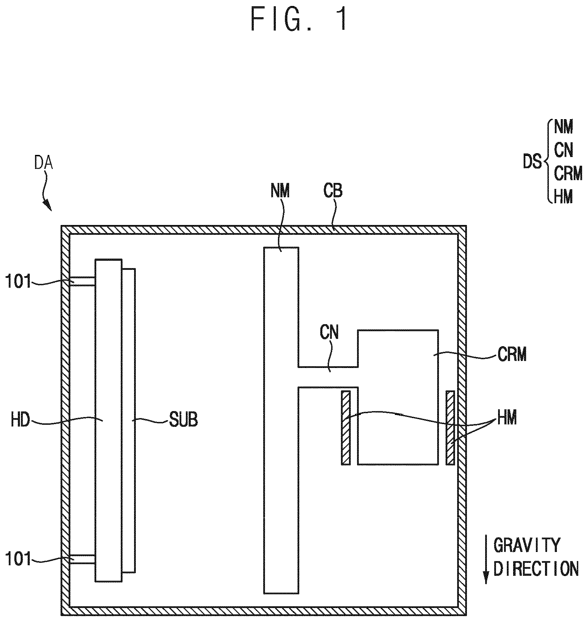

FIG. 1 is a schematic sectional view schematically showing a deposition apparatus according to an embodiment of the disclosure.

Referring to FIG. 1, according to an embodiment of the disclosure, a deposition apparatus DA may include a process chamber CB, a deposition source DS, and a substrate holder HD. The deposition source DS may include a nozzle member (nozzle) NM, a connection member (connection structure) CN, a crucible member CRM, and a heating member HM.

The process chamber CB may provide a space for performing a deposition process. The process chamber CB may be connected to a vacuum pump that controls a pressure inside the process chamber CB, and exhaust a deposition material that is not deposited on a substrate SUB. The process chamber CB may have a rectangular parallelepiped shape. For example, the process chamber CB may include a conductive material. However, embodiments of the disclosure are not limited thereto.

The deposition source DS may be disposed on a side surface of the process chamber CB, and the substrate holder HD may be disposed on an opposite side surface of the process chamber CB. In detail, the deposition source DS may have a shape extending in a direction. According to an embodiment, the deposition source DS may have a shape extending in a gravity direction. The deposition source DS may store the deposition material, heat the deposition material, and spray the heated deposition material onto the substrate SUB so as to form a film with the deposition material on the substrate SUB.

As described above, the substrate holder HD may be disposed on the opposite side surface of the process chamber CB. The substrate holder HD may be disposed inside the process chamber CB. The substrate holder HD may perform a function of seating the substrate SUB transferred into the process chamber CB. The substrate holder HD may be fixed to the process chamber CB by a fixing member 101.

The deposition source DS may include a nozzle member NM, a connection member CN, a crucible member CRM, and a heating member HM.

The nozzle member NM may be connected to the crucible member CRM. In detail, the nozzle member NM may be connected to the crucible member CRM through the connection member CN. For example, the crucible member CRM may be spaced apart from the nozzle member NM. In other words, the deposition source DS may be configured such that the nozzle member NM and the crucible member CRM are separated from each other. The crucible member CRM may store a deposition material DM inside the crucible member CRM. The nozzle member NM and the crucible member CRM will be described in detail below.

The connection member CN may be connected to the nozzle member NM and the crucible member CRM. The connection member CN may provide a space through which the deposition material DM that is present inside the crucible member CRM moves to the nozzle member NM. In other words, the connection member CN may transfer the deposition material DM from the crucible member CRM to the nozzle member NM.

The connection member CN may include a heat-resistant material. For example, the connection member CN may include a heat-resistant material such as a metal, an alloy, ceramic, and/or glass. These may be used alone or in combination with each other. However, the configuration of embodiments of the disclosure are not limited thereto, and the connection member CN may include various heat-resistant materials.

The heating member HM may be adjacent to the crucible member CRM. The heating member HM may heat the crucible member CRM. In detail, the heating member HM may heat the crucible member CRM to vaporize the deposition material DM that is present inside the crucible member CRM.

The vaporized deposition material DM may be transferred to the nozzle member NM through the connection member CN. The nozzle member NM may spray the vaporized deposition material DM onto the substrate SUB.

The deposition material DM may be a material that may be vaporized by heat. For example, the deposition material DM may include a metal material, an inorganic insulating material, and the like. The metal material may include a metal, an alloy, a metal nitride, a conductive metal oxide, a transparent conductive material, and the like. The inorganic insulating material may include silicon oxide, silicon nitride, and the like. These may be used individually or in combination with each other. However, embodiments of the disclosure are not limited thereto.

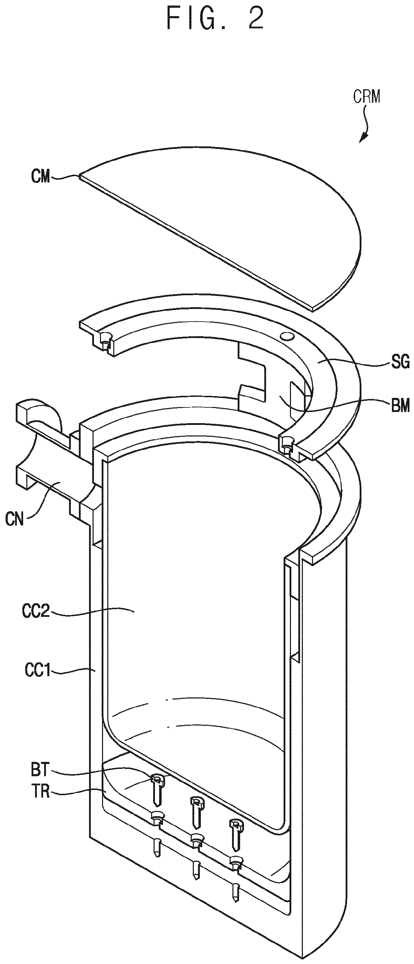

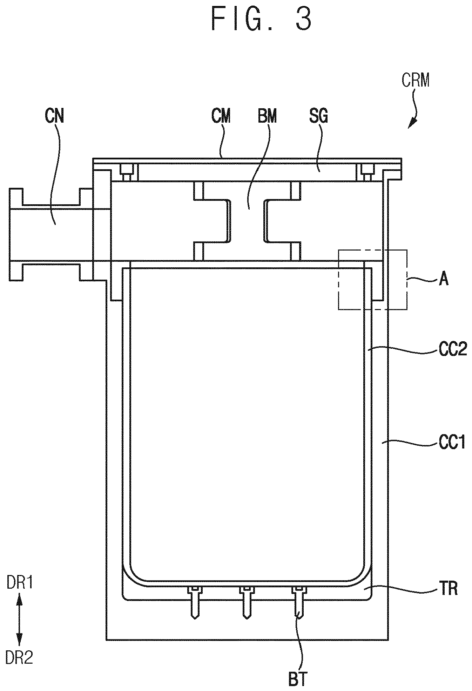

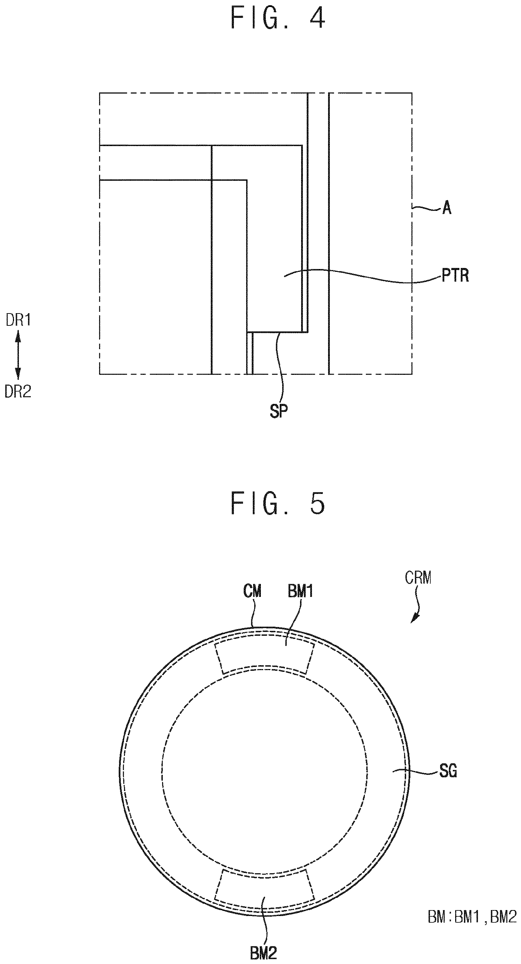

FIG. 2 is an exploded schematic perspective view showing a crucible member included in a deposition source according to an embodiment of the disclosure. FIG. 3 is a schematic sectional view showing the crucible member of FIG. 2. FIG. 4 is an enlarged schematic sectional view showing region A of FIG. 3. FIG. 5 is a schematic plan view showing the crucible member of FIG. 2.

FIGS. 2 and 3 are views showing an inside of the crucible member CRM after cutting a section of the crucible member CRM.

Referring to FIGS. 2 and 3, the crucible member CRM may include a first crucible CC1, a second crucible CC2, a tray TR, a block member (block) BM, a cover member (cover) CM, and a sealing gasket SG.

The first crucible CC1 may include a metal material. The first crucible CC1 may seat the second crucible CC2 inside the first crucible CC1.

The second crucible CC2 may be disposed inside the first crucible CC1. The second crucible CC2 may store the deposition material inside the second crucible CC2. The second crucible CC2 may include a non-metal material. In other words, the first crucible CC1 and the second crucible CC2 may include mutually different materials.

Referring further to FIG. 4, the first crucible CC1 may include a seating part SP recessed inward of the first crucible CC1. The second crucible CC2 may include a protruding part PTR protruding outward of the second crucible CC2. The protruding part PTR may have a shape surrounding an outer side of the second crucible CC2. The seating part SP may have a shape surrounding an inner side of the first crucible CC1.

In case that the second crucible CC2 is disposed inside the first crucible CC1, the protruding part PTR may be seated in the seating part SP. In other words, the second crucible CC2 may be affected by gravity due to a weight of the second crucible CC2. Accordingly, the protruding part PTR included in the second crucible CC2 may make contact with the seating part SP included in the first crucible CC1.

Referring again to FIGS. 2 and 3, the tray TR may be disposed between the first crucible CC1 and the second crucible CC2. In detail, the tray TR may be disposed inside the first crucible CC1 while being disposed under the second crucible CC2. The tray TR may be coupled to the first crucible CC1. For example, the tray TR may be coupled to the first crucible CC1 with a bolt BT. Therefore, the tray TR may be firmly fixed to the first crucible CC1, and a gap between the tray TR and the first crucible CC1 may be minimized. However, a coupling scheme of embodiments is not limited thereto.

The tray TR may serve as a material receiver that accommodates the deposition material that has entered between the first crucible CC1 and the second crucible CC2. The tray TR may reduce a lower gap between the first crucible CC1 and the second crucible CC2.

The tray TR may include a non-metal material. Since both the tray TR and the second crucible CC2 include a non-metal material, even after the deposition process is finished, the tray TR and the second crucible CC2 may be readily separated from each other.

The tray TR and the second crucible CC2 may include the same material. However, embodiments of the disclosure are not limited thereto.

Referring further to FIG. 5, the block member BM may be disposed inside the first crucible CC1. The block member BM may be disposed on at least a portion of the second crucible CC2. The block member BM may apply a pressure to the second crucible CC2, which floats in a first direction DR1, in a second direction DR2. The second direction DR2 may be opposite to the first direction DR1, and may be the gravity direction. Therefore, the block member BM may prevent the second crucible CC2 from floating.

The block member BM may include a first block member (a first block) BM1 and a second block member (a second block) BM2. The first block member BM1 may be spaced apart from the second block member BM2. For example, the first block member BM1 may be disposed at a position facing the second block member BM2. Since the first block member BM1 and the second block member BM2 are disposed at positions facing each other, the second crucible CC2 may more effectively be prevented from floating, and the second crucible CC2 may be prevented from being inclined. However, embodiments of the disclosure are not limited thereto, and the block member BM may include only one block member, or at least three block members.

The cover member CM may cover a top surface of the first crucible CC1. The cover member CM may serve as a cover for the first crucible CC1. The sealing gasket SG may be disposed between the cover member CM and the first crucible CC1. The sealing gasket SG may seal the first crucible CC1.

The cover member CM may be disposed on the block member BM. The sealing gasket SG may be disposed between the cover member CM and the block member BM. The cover member CM and the sealing gasket SG may apply a pressure to the block member BM in the second direction DR2. Therefore, the second crucible CC2 may be prevented from floating through the block member BM.

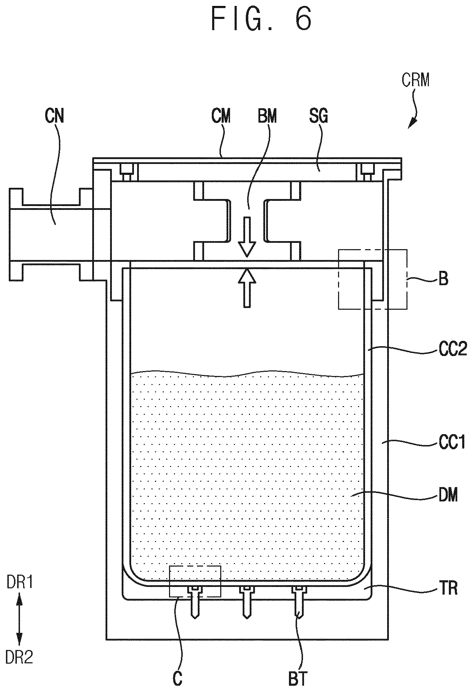

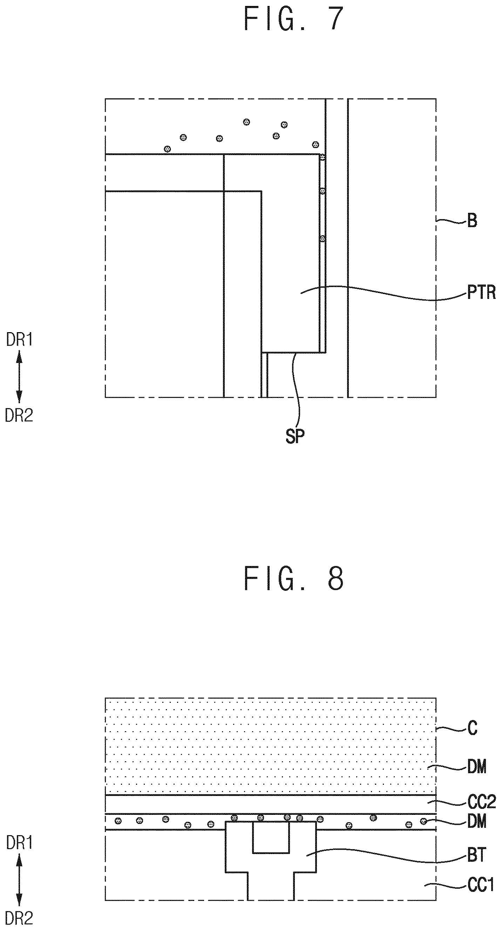

FIG. 6 is a schematic sectional view for describing the crucible member included in the deposition source according to an embodiment of the disclosure. FIG. 7 is an enlarged schematic sectional view showing region B of FIG. 6. FIG. 8 is an enlarged schematic sectional view showing region C of FIG. 6.

Referring further to FIGS. 6 and 7, according to an embodiment, the deposition material DM stored inside the second crucible CC2 may be vaporized. The vaporized deposition material DM may float on the second crucible CC2, or may be transferred to a nozzle member (e.g., the nozzle member NM of FIG. 1) through the connection member CN.

The floating deposition material DM may reach a gap between the first crucible CC1 and the second crucible CC2. However, since the protruding part PTR and the seating part SP make contact with each other due to the weight of the second crucible CC2, a gap between the protruding part PTR and the seating part SP may be substantially eliminated.

Therefore, the deposition material DM floating on the second crucible CC2 may not readily enter the gap between the first crucible CC1 and the second crucible CC2. Thus, a defect caused by the deposition material DM may be reduced.

Referring further to FIG. 8, however, the deposition material DM may pass through the protruding part PTR and the seating part SP to enter the gap between the first crucible CC1 and the second crucible CC2. In case that the deposition material DM enters the gap between the first crucible CC1 and the second crucible CC2, the deposition material DM may be disposed on the tray TR.

Since a gap between the tray TR and the second crucible CC2 is small, an amount of the deposition material DM entering the gap between the tray TR and the second crucible CC2 may be small. Even in case that the deposition material DM is collected on the tray TR, since the gap between the tray TR and the second crucible CC2 is small, the deposition material DM may not be agglomerated.

Referring again to FIG. 6, however, even in case that the second crucible CC2 is to float in the first direction DR1 due to the deposition material DM, the second crucible CC2 may be prevented from floating by the block member BM. In detail, the block member BM disposed on the second crucible CC2 may apply a pressure to the second crucible CC2 in the second direction DR2. Therefore, the second crucible CC2 may maintain an original position without floating in the first direction DR1.

Thus, since the deposition source DS includes the protruding part PTR, the seating part SP, the tray TR, and the block member BM, the second crucible CC2 inside the first crucible CC1 may be prevented from floating by the deposition material DM. Therefore, a change in a position of the second crucible CC2 may be prevented so that an evaporation surface area of the deposition material DM may be prevented from being changed, and since the change in the position of the second crucible CC2 is prevented, an interference with a flow of the deposition material DM may be minimized. Thus, deposition quality of the deposition source DS may be improved.

The deposition material DM may be prevented from being agglomerated and hardened in a lower portion of the second crucible CC2, so that the second crucible CC2 may be readily detached from the first crucible CC1. Therefore, maintenance and repair of the deposition source DS may be facilitated.

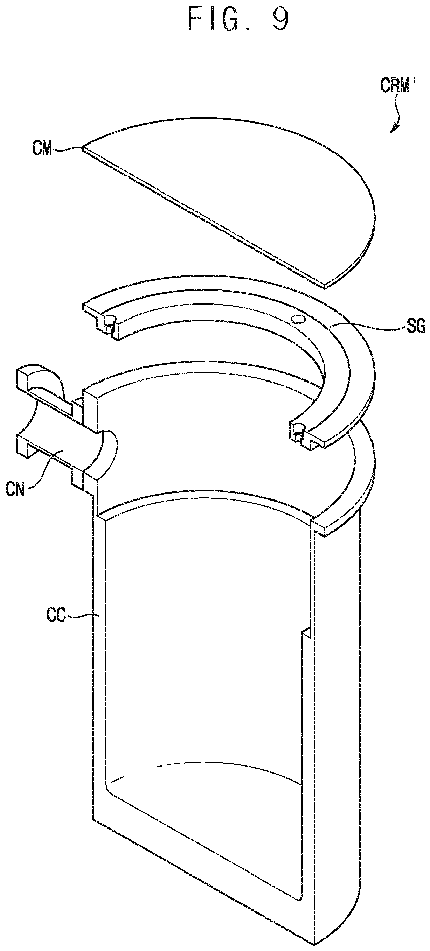

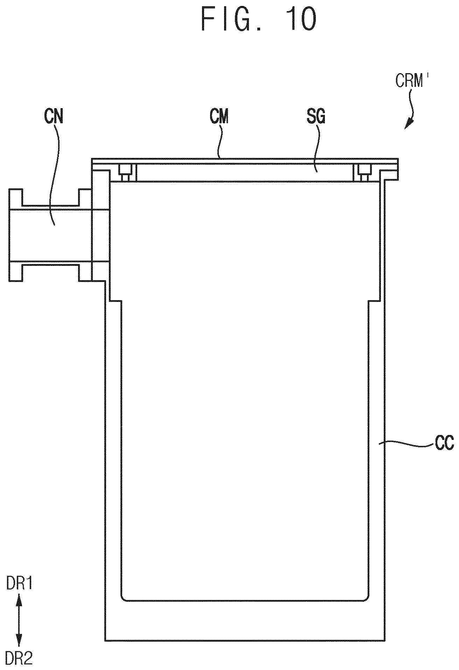

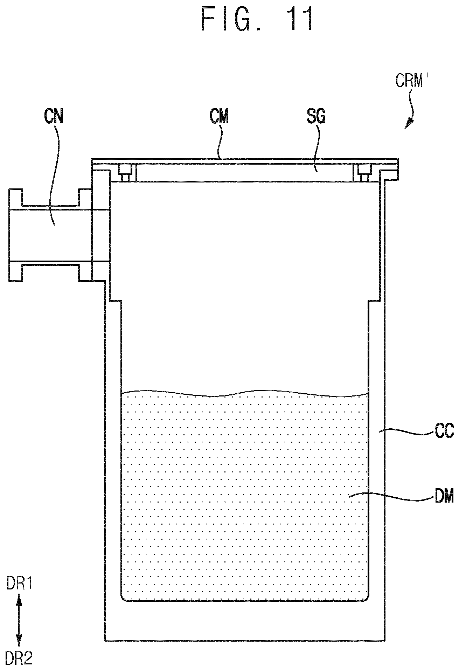

FIG. 9 is an exploded schematic perspective view showing a crucible member included in a deposition source according to another embodiment of the disclosure. FIG. 10 is a schematic sectional view showing the crucible member of FIG. 9. FIG. 11 is a schematic sectional view for describing the crucible member included in the deposition source according to another embodiment of the disclosure.

FIGS. 9 and 10 are views showing an inside of a crucible member CRM' after cutting a section of the crucible member CRM'. FIG. 11 is a view showing a state in which the deposition material DM is stored in the crucible member CRM' of FIG. 10.

Referring to FIGS. 1, 9, 10, and 11, the deposition source may include a nozzle member NM, a connection member CN, a heating member HM, and a crucible member CRM'.

In detail, the nozzle member NM may be connected to the crucible member CRM' through the connection member CN. For example, the crucible member CRM' may be spaced apart from the nozzle member NM. In other words, the deposition source may be configured such that the nozzle member NM and the crucible member CRM' are separated from each other. The nozzle member NM may spray a deposition material (e.g., the deposition material DM of FIG. 6).

The crucible member CRM' may include a crucible CC, a cover member CM, and a sealing gasket SG.

The crucible CC may be connected to the nozzle member NM. The crucible CC may store the deposition material (e.g., the deposition material DM of FIG. 6) in an inside of the crucible CC. The inside of the crucible CC may make direct contact with the deposition material. In other words, the crucible member CRM' may not require an additional crucible other than the crucible CC.

The crucible CC may include a non-metal material. Therefore, the deposition material may be readily peeled off from the crucible CC.

The cover member CM may cover a top surface of the crucible CC. The sealing gasket SG may be disposed between the cover member CM and the crucible CC. The sealing gasket SG may seal the crucible CC.

According to an embodiment, since the deposition source may include only one crucible CC, a defect caused by floating of an additional crucible inside the deposition source due to the deposition material may be prevented. Therefore, an evaporation surface area of the deposition material stored inside the crucible member CRM' may be prevented from being changed, and an interference with a flow of the deposition material caused by the crucible CC may be minimized. Thus, deposition quality of the deposition source may be improved.

Since the deposition source may include only one crucible CC, and may include a non-metal material, peeling of the deposition material may be facilitated. Therefore, maintenance and repair of the deposition source may be facilitated.

As discussed, embodiments can provide a deposition source, comprising: a first crucible; a second crucible disposed inside the first crucible; a block disposed inside the first crucible, the block being disposed on at least a portion of the second crucible; and a cover covering a top surface of the first crucible, the cover being disposed on the block.

In some embodiments, the second crucible includes a protruding part, the first crucible includes a seating part, and the protruding part is seated on the seating part.

The first crucible may include a metal material. The first crucible may seat the second crucible inside the first crucible.

The second crucible may store the deposition material inside the second crucible. The second crucible may include a non-metal material. In other words, the first crucible and the second crucible may include mutually different materials.

The first crucible may include a seating part recessed inward of the first crucible. The second crucible may include a protruding part protruding outward of the second crucible. The protruding part may have a shape surrounding an outer side of the second crucible. The seating part may have a shape surrounding an inner side of the first crucible. Accordingly, the protruding part included in the second crucible may make contact with the seating part included in the first crucible.

A tray may be disposed between the first crucible and the second crucible. In detail, the tray may be disposed inside the first crucible while being disposed under the second crucible. The tray may be coupled to the first crucible. For example, the tray may be coupled to the first crucible with a bolt.

The tray may serve as a material receiver that accommodates the deposition material that has entered between the first crucible and the second crucible. The tray TR may reduce a lower gap between the first crucible and the second crucible.

The tray may include a non-metal material.

The block member may be disposed on at least a portion of the second crucible. The block member may apply a pressure to the second crucible, which may otherwise float in a first direction, in a second direction. The second direction may be opposite to the first direction, and may be the gravity direction. Therefore, the block member may prevent the second crucible from floating.

The block member may include a first block member (a first block) and a second block member (a second block). The first block member may be spaced apart from the second block member. For example, the first block member may be disposed at a position facing the second block member. Since the first block member and the second block member are disposed at positions facing each other, the second crucible may more effectively be prevented from floating, and the second crucible may be prevented from being inclined.

The cover member may cover a top surface of the first crucible. The cover member may serve as a cover for the first crucible. The sealing gasket may be disposed between the cover member and the first crucible. The sealing gasket may seal the first crucible.

The cover member may be disposed on the block member. The sealing gasket may be disposed between the cover member and the block member. The cover member and the sealing gasket may apply a pressure to the block member in the second direction. Therefore, the second crucible may be prevented from floating through the block member.

In use, the deposition material stored inside the second crucible may be vaporized. The vaporized deposition material may float on the second crucible, or may be transferred to a nozzle member through a connection member.

The connection member may be arranged under the cover, to project from a side surface of the crucible member.

Embodiments may also provide a deposition source, comprising: a nozzle arranged to spray a deposition material; and a crucible connected to the nozzle, wherein the crucible includes a non-metal material, and the crucible is arranged to store the deposition material in an inside of the crucible.

Display devices according to embodiments of the disclosure may be applied to display devices included in a computer, a laptop computer, a mobile phone, a smart phone, a smart pad, an automobile, a PMP, a PDA, an MP3 player, and the like.

Although the embodiments of the disclosure have been described above, it will be understood by those of ordinary skill in the art that various changes and modifications can be made to the disclosure without departing from the idea and scope of the disclosure.

## Claims

1. A deposition source, comprising:
a first crucible;
a second crucible disposed inside the first crucible;
a block disposed inside the first crucible, the block being disposed on at least a portion of the second crucible; and
a cover covering a top surface of the first crucible, the cover being disposed on the block.

2. The deposition source of claim 1, wherein
the second crucible includes a protruding part,
the first crucible includes a seating part, and
the protruding part is seated on the seating part.

3. The deposition source of claim 1 or 2, wherein the second crucible includes a non-metal material.

4. The deposition source of any one of claims 1 to 3, further comprising:
a tray disposed between the first crucible and the second crucible.

5. The deposition source of claim 4, wherein the tray includes a non-metal material.

6. The deposition source of any one of claims 1 to 5, wherein the first crucible includes a metal material.

7. The deposition source of any one of claims 1 to 6, wherein the block includes:
a first block; and
a second block spaced apart from the first block.

8. The deposition source of claim 7, wherein the first block and the second block face each other.

9. The deposition source of any one of claims 1 to 8, further comprising:
a sealing gasket disposed between the cover and the first crucible, wherein the sealing gasket is disposed between the cover and the block.

10. The deposition source of any one of claims 1 to 9, wherein the second crucible is arranged to store a deposition material inside the second crucible.

11. The deposition source of claim 10, further comprising:
a nozzle arranged to spray the deposition material; and
a connection structure connected to the first crucible and the nozzle,
wherein the connection structure is arranged to transfer the deposition material to the nozzle.

12. A deposition source, comprising:
a nozzle arranged to spray a deposition material; and
a crucible connected to the nozzle, wherein
the crucible includes a non-metal material, and
the crucible is arranged to store the deposition material in an inside of the crucible.

13. The deposition source of claim 12, further comprising:
a connection structure connecting the nozzle to the crucible.

14. The deposition source of claim 12 or 13, further comprising:
a cover covering a top surface of the crucible.

15. The deposition source of claim 14, further comprising:
a sealing gasket disposed between the cover and the crucible.
